# EUROPEAN PATENT APPLICATION

(11) **EP 0 624 002 A2**
(43) Date of publication of application: **09.11.1994**
(21) Application number: 94302566.8
(22) Date of filing: 12.04.1994
(51) Int. Cl.: H04B 1/38, H05K 5/02, H01Q 1/22

(54) **Housings for transmitter/receiver units**

(30) Priority: 06.05.1993 GB 9309303
(71) Applicant: PLESSEY SEMICONDUCTORS LIMITED, Swindon, Wiltshire SN2 2QW (GB)
(72) Inventor: Forshaw, John Andrew, Bassingham, Lincoln LN5 9JS (GB)
(74) Representative: Hoste, Colin Francis

(57) **Abstract**

A fold-up housing for a radio local area network (LAN) transmitter/receiver unit designed to plug in to a Personal Computer Memory Card International Association (PCMCIA) memory expansion socket of a notebook computer.

## Description

The present invention relates to housings for transmitter/receiver units, and in particular to housings for transmitter/receiver units for use in radio local area networks (LANs).

Notebook computers are presently being produced which are equipped to accept Personal Computer Memory Card International Association (PCMCIA) memory expansion cards, and transmitter/receiver units are being developed which plug in in place of such memory expansion cards. These units, which comprise a computer interface, a LAN controller and radio transmitter/receiver circuits operating at Carrier frequencies of the order of 2.4GHz, can provide 1 Mbit/sec data links for such notebook computers over in-building ranges of a hundred feet or more.

According to one aspect of the present invention a housing for a local area network radio transmitter/receiver unit for a computer comprises a first part cooperable with plug and socket connector means of the computer for the transfer of data between said transmitter/receiver unit and said computer, and a second part connected to said first part for pivotal movement relative to said first part between a first position in which said parts are at least closely adjacent one another and a second position in which said second part is rotated to lie at an angle to the direction of insertion of said first part into said plug and socket connector means, said second part housing at least the antenna means of said transmitter/receiver unit.

According to another aspect of the present invention a local area network radio transmitter/receiver unit for use with a computer equipped with socket means arranged to accept a PCMCIA memory expansion card comprises a two-part housing of which a first part is adapted for insertion into said socket means in place of a PCMCIA memory expansion card and a second part is connected to said first part for pivotal movement relative to said first part between a closed or transit position in which said parts lie at least closely adjacent one another and an operative position in which said second part is rotated relative to said first part such that said first part may be inserted into said socket means.

Preferably said first part of said housing carries interface circuit means, and said second part of said housing carries at least the antenna means of said transmitter/receiver unit. The two parts maybe connected by means of a double hinge arrangement having means to retain or to bias the two parts in particular angular relationships. The second part of said housing may be arranged partially to enclose the first part in said closed position.

A housing for a transmitter/receiver unit in accordance with the present invention will now be described by way of example with reference to the accompanying drawing, of which:-
- Figure 1: shows a side elevation of the housing in a closed position,
- Figure 2: shows a side elevation of the housing in an open or operative position, and
- Figure 3: shows a plan view of the housing in the open or operative position.

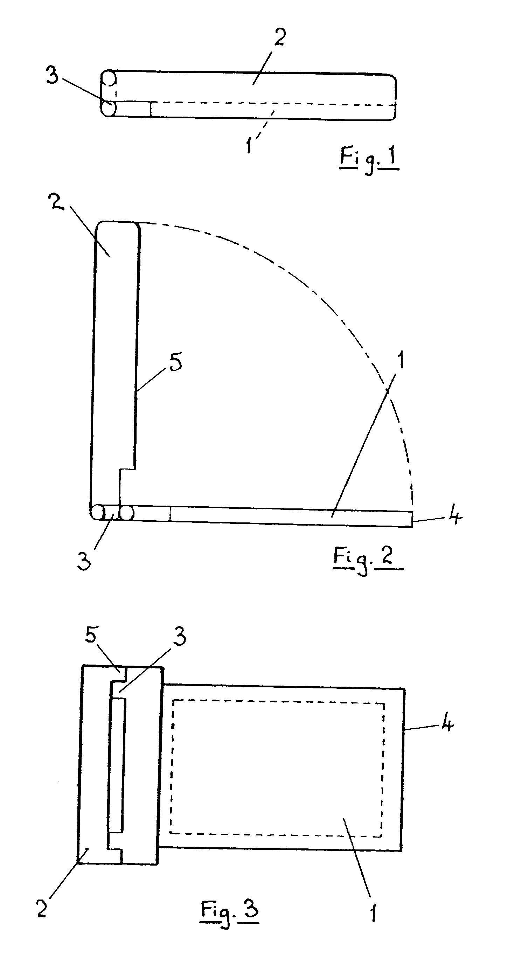

Referring to the drawing the housing comprises two parts 1 and 2 connected by a double hinge 3, the part 1 having generally the size and format of a PCMCIA memory expansion card, some 54mm wide by 86mm long and 5mm thick, having at its free end 4 a plug and socket type connector (not shown) for connection to its counterpart connector provided in a notebook computer (not shown). In the closed position shown in Figure 1 flanges 5 on the second part 2 extend over the edge of the part 1 either on the two sides, as shown, or on the two sides and the free end 4 (not shown).

The part 1 may carry interface circuitry (not shown) and a LAN controller, while the part 2 may carry transmitter/receiver circuits and the necessary antenna. The double hinge 3 maybe provided with detents (not shown) to hold the two parts of the housing in particular angular relationships, such as the right-angle position indicated in Figures 2 and 3.

## Claims

1. A housing for a local area network radio transmitter/receiver unit for a computer comprising a first part cooperable with plug and socket connector means of the computer for the transfer of data between said transmitter/receiver unit and said computer, and a second part connected to said first part for pivotal movement relative to said first part between a first position in which said parts are at least closely adjacent one another and a second position in which said second part is rotated to lie at an angle to the direction of insertion of said first part into said plug and socket connector means, said second part housing at least the antenna means of said transmitter/receiver unit.

2. A local area network radio transmitter/receiver unit for use with a computer equipped with socket means arranged to accept a PCMCIA memory expansion card comprising a two-part housing of which a first part is adapted for insertion into said socket means in place of a PCMCIA memory expansion card and a second part is connected to said first part for pivotal movement relative to said first part between a closed or transit position in which said parts lie at least closely adjacent one another and an operative position in which said second part is rotated relative to said first part such that said first part may be inserted into said socket means.

3. A transmitter/receiver unit in accordance with Claim 2 wherein said first part of said housing carries interface circuit means, and said second part of said housing carries at least the antenna means of said transmitter/receiver unit.

4. A transmitter/receiver unit in accordance with Claim 2 or Claim 3 wherein the two parts are connected by means of a double hinge arrangement having means to retain or to bias the two parts in particular angular relationships.

5. A transmitter/receiver unit in accordance with Claim 2,or Claim 3 wherein the second part of said housing is arranged partially to enclose the first part in said closed position.
